(19)

Europäisches Patentamt

European Patent Office

Office européen des brevets

(11) **EP 4 400 253 A1**

(12) **EUROPEAN PATENT APPLICATION**

(43) Date of publication:
**17.07.2024 Bulletin 2024/29**

(21) Application number: **24151702.8**

(22) Date of filing: **12.01.2024**

(51) International Patent Classification (IPC):
**B23K 35/26** (2006.01)     **C22C 13/00** (2006.01)
**C22C 13/02** (2006.01)     **B23K 35/02** (2006.01)
**H05K 3/34** (2006.01)

(52) Cooperative Patent Classification (CPC):
**B23K 35/262; B23K 35/0244; B23K 35/025;
C22C 13/00; C22C 13/02; H05K 3/3463;
H05K 3/3485**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **12.01.2023 JP 2023002973**

(71) Applicant: **Senju Metal Industry Co., Ltd.**
**Tokyo 120-8555 (JP)**

(72) Inventors:
• **YOKOYAMA, Takahiro**
**Tokyo, 120-8555 (JP)**

• **YOSHIKAWA, Shunsaku**
**Tokyo, 120-8555 (JP)**
• **IIJIMA, Yuki**
**Tokyo, 120-8555 (JP)**
• **DEI, Kanta**
**Tokyo, 120-8555 (JP)**
• **MATSUFUJI, Takahiro**
**Tokyo, 120-8555 (JP)**
• **SUGISAWA, Kota**
**Tokyo, 120-8555 (JP)**
• **SUZUKI, Shigeto**
**Tokyo, 120-8555 (JP)**

(74) Representative: **Zimmermann & Partner
Patentanwälte mbB
Postfach 330 920
80069 München (DE)**

(54) **SOLDER ALLOY, SOLDER PASTE, SOLDER BALL, SOLDER PREFORM, SOLDER JOINT, VEHICLE-MOUNTED ELECTRONIC CIRCUIT, ECU ELECTRONIC CIRCUIT, VEHICLE-MOUNTED ELECTRONIC CIRCUIT DEVICE, AND ECU ELECTRONIC CIRCUIT DEVICE**

(57)    Provided are a solder alloy, a solder paste, a solder ball, a solder preform, a solder joint, a vehicle-mounted electronic circuit, an ECU electronic circuit, a vehicle-mounted electronic circuit device, and an ECU electronic circuit device which have a liquidus-line temperature and a solidus-line temperature falling within predetermined temperature ranges, and have excellent heat conductivity, and excellent heat cycle resistance. The solder alloy has an alloy composition consisting of, by mass%, Ag: 3.0 to 3.8%, Cu: 0.1 to 1.0%, Bi: more than 0% and less than 1.5%, Sb: 1.0 to 7.9%, Fe: 0.020 to 0.040%, Co: more than 0.008% and 0.020% or less, with the balance being Sn. Preferably, the solder alloy further contains, by mass%, at least one of Ge, Ga, As, Pd, Mn, In, Zn, Zr, and Mg: 0.1% or less in total.

Fig. 1

target region

NONE    COMPO  15.0kV  X1,000  WD 6.7mm  10μm

EP 4 400 253 A1

**Description**

Technical Field

The present invention relates to a solder alloy, a solder paste, a solder ball, a solder preform, a solder joint, a vehicle-mounted electronic circuit, an ECU electronic circuit, a vehicle-mounted electronic circuit device, and an ECU electronic circuit device.

Background Art

In an automobile, vehicle-mounted electronic circuits to be used for devices which electrically control the engine, power steering, and brake, etc., are installed. The vehicle-mounted electronic circuits are security components essential for traveling of the automobile. In particular, a vehicle-mounted electronic circuit called ECU (Engine Control Unit) of an electronic circuit that controls the automobile with a computer for fuel efficiency improvement needs to operate in a stable state without failures for a long period of time. Generally, many ECUs are installed in the vicinity of the engine, and their usage environments operate under harsh conditions.

The vicinity of the engine where such a vehicle-mounted electronic circuit is installed reaches an extremely high temperature of 125°C or more during rotation of the engine. On the other hand, when the rotation of the engine is stopped, the vicinity of the engine reaches a low temperature of -40°C or less in winter in a cold weather region, for example, North America and Siberia, etc. Therefore, the vehicle-mounted electronic circuit is exposed to a heat-cycle environment of at least -40°C to +125°C due to repetition of engine operation and engine stoppage.

The vehicle-mounted electronic circuit is an electronic circuit that electronic components are soldered to a printed circuit board. Linear thermal expansion coefficients of the electronic components are greatly different from a linear thermal expansion coefficient of the printed circuit board. When the vehicle-mounted electronic circuit is exposed to a heat-cycle environment, each of the electronic components and the printed circuit board repeats thermal expansion and contraction. Due to this repetition, a certain degree of thermal displacement occurs at soldered portions (hereinafter, referred to as "solder joints") that join the electronic components and the printed circuit board. Therefore, in a heat-cycle environment, stress is continuously applied to the solder joints, and eventually causes breakage of the solder joints.

Even when the solder joints are not completely broken, their partial breakage may increase the resistance value of the electronic circuit and cause erroneous operation. Erroneous operation of the ECU installed in an automobile may lead to a serious accident. Therefore, in order to avoid erroneous operation of the ECU, improvement in heat cycle resistance is particularly important.

Therefore, for example, in Patent Document 1, as a solder alloy with high heat cycle resistance, an Sn-Ag-Cu-Bi-Sb-Co-Fe solder alloy is disclosed. This solder alloy is excellent not only in heat cycle resistance but also in acoustic quality.

Citation List

Patent Document

Patent Document 1: Japanese Patent Publication No. 6889387

Summary of Invention

Technical Problem

In Patent Document 1, an alloy composition not containing Ni so as to prevent compounds that precipitate at a joint interface from being liberated in the solder alloy is disclosed. Here, the heat cycle resistance of the solder alloy described in Patent Document 1 was evaluated through a heat cycle test in which a heat cycle from -55°C to 150°C was repeated 3000 times. However, the heat conductivity required as a solder joint must not deteriorate in accordance with excessive specifications of the heat cycle resistance.

In recent years, electronic components have been increasingly downsized, and a large current is supplied according to improvement in performance. From the viewpoint of preventing erroneous operation of electronic components, heat radiation of electronic components is a big problem for electronic circuits. Heat radiation means of electronic components are attachment of a heatsink, etc. However, when the heat conductivity of the solder joint is improved, heat radiation of electronic circuits without installation of a large heatsink can be expected. Downsizing of the heatsink improves, for example, the degree of freedom in installation of a vehicle-mounted electronic circuit when the vehicle-mounted electronic circuit is installed in an automobile.

In this way, solder joints are desired to be improved not only in heat cycle resistance but also in heat conductivity that has become a problem in recent years. Although the solder alloy described in Patent Document 1 has excellent acoustic quality, further studies are required to realize an improvement in heat conductivity as properties necessary for solder joints.

Therefore, an object of the present invention is to provide a solder alloy, a solder paste, a solder ball, a solder preform, a solder joint, a vehicle-mounted electronic circuit, an ECU electronic circuit, a vehicle-mounted electronic circuit device, and an ECU electronic circuit device which have a liquidus-line temperature and a solidus-line temperature falling within predetermined temperature ranges, and have excellent heat conductivity, and excellent heat cycle resistance.

Solution to Problem

In the Sn-Ag-Cu-Bi-Sb-Fe-Co solder alloy disclosed in Patent Document 1, the inventors examined a composition which improved not only the heat cycle resistance but also the heat conductivity. In order to realize both of the heat cycle resistance and the heat conductivity, in the solder alloy described in Patent Document 1, attention is focused on a decrease in Bi content. Bi can improve the heat cycle resistance and lower the melting point. However, Bi has properties of segregating at the time of solidification of molten solder, and a high Bi content hinders solidification of molten solder, and is presumed to decrease a temperature of a supercooled state, and cause supercooling of the molten solder.

Supercooling is a state where solidification does not occur at a solidifying temperature in an equilibrium state. Here, in a solder alloy primarily consisting of Sn, when supercooling occurs, the lower the temperature of the supercooled state, the finer the crystal grains of Sn become. The reason for this is considered that a change in state from a liquid to a solid occurs in an extremely short time since the temperature of the supercooled state is much lower than a solidification starting temperature. On the other hand, as described above, Sn in a supercooled state is maintained in a liquid state, so that a compound that becomes a primary crystal in the molten solder and an intermetallic compound formed at a joint interface between an electrode and the solder alloy are presumed to coarsen and embrittle.

Next, in order to suppress supercooling, the solidification starting temperature must be high. Therefore, crystal grains of Sn become large. On the other hand, a compound that becomes a primary crystal in the molten solder and an intermetallic compound formed at a joint interface between an electrode and the solder alloy are refined since the solidification starting temperature of Sn becomes high. The reason for this is presumed that a rate of diffusion of solid-phase diffusion of the compound and Sn in a solid state is lower than a rate of solid-liquid diffusion of the compound and Sn in a liquid state, and growth of the compound is suppressed. As in the case of the solder alloy described in Patent Document 1, supercooling of a solder alloy containing Bi and Sb is suppressed when it contains Fe and Co that function as a solidification nucleus, so that crystal grains of Sn are also presumed to be refined as well as the compound. Behaviors of molten solder in the Sn-Ag-Cu-Bi-Sb-based solder alloys when cooled are as described in the following Table 1.

[Table 1]

| Alloy structure portion | Alloy structure | Not containing Fe and Co | Containing Fe and Co | |
|---|---|---|---|---|
| | | Supercooled | Suppression of supercooling + insufficient contents of Fe and Co | Suppression of supercooling + proper contents of Fe and Co |
| Inside solder alloy | Sn crystal grain | Fine | Coarse | Fine |
| | Compound (Cu$_6$Sn$_5$ and Ag$_3$Sn) | Coarse, Brittle | Fine | Fine |
| Joint portion | IMC (compound) | Coarse | Fine | Fine |

As described above, in the Sn-Ag-Cu-Bi-Sb-Fe-Co solder alloy, Bi decreases the temperature of the supercooled state, and in order to prevent the decrease in supercooling temperature, a decrease in Bi content may be employed. Generally, in a solder alloy, each of the constituent elements does not separately function, and unique effects of the solder alloy are exerted only when all of the constituent elements become integrated. Therefore, in the solder alloy described in Patent Document 1, the inventors conducted further studies on a solder alloy that could resist a heat-cycle test equivalent to a load that caused no problem in practical use for a solder joint and exhibited high heat conductivity.

A fine alloy structure contributes to an improvement in heat cycle resistance. This is considered to be accomplished by suppressing supercooling and by containing an element that contributes to an increase in number of crystal nuclei. Here, a fine structure is considered to deteriorate the heat conductivity since it increases the crystal grain boundary area. However, the heat conductivity of compounds which precipitate in the solder alloy is low. Therefore, precipitation of large amounts of the compounds more greatly contributes to the decrease in heat conductivity than the increase in crystal grain boundary area. As an alloy structure, even when fine Sn crystal grains precipitate, a decrease in heat conductivity can be avoided by reducing the precipitation amount of the compounds.

However, even in the case where the Bi content is reduced, when a compound with low heat conductivity precipitates at the joint interface and is liberated in the solder alloy, the heat conductivity is deteriorated. Therefore, both of the effects cannot be realized just by the Bi content reduction. In order to improve the heat conductivity while maintaining the heat cycle resistance, it is desirable that the compound is prevented from being liberated in the solder alloy from the joint interface of the solder joint.

Here, liberation is a phenomenon in which, when a compound precipitates in large amounts at a joint interface of a solder joint according to step soldering or aging, the compound that precipitates at the joint interface moves to the inside of the solder alloy. The liberation easily occurs as the compound at the joint interface becomes finer. Therefore, in Patent Document 1, from the viewpoint of acoustic quality, an alloy composition not containing Ni which makes fine the compound at the joint interface is proposed. However, in the present invention, in view of an improvement in heat conductivity, the heat conductivity needs to be improved not only by preventing the liberation but also by further reducing the precipitation amount of the Bi phase.

On the other hand, in the Sn-Ag-Cu-Bi-Sb-Fe-Co solder alloy, compounds that contribute to the heat cycle resistance are, for example, SnSb, etc. If the amount of SnSb is proper, high heat cycle resistance can be shown while suppressing an increase in melting point. For an improvement in heat cycle resistance, precipitation of a predetermined amount of a compound such as SnSb is necessary.

As described, in consideration of the alloy structure, the heat cycle resistance and the heat conductivity have directions that are mutually exclusive, and therefore, it was difficult to exert these effects at the same time in conventional solder alloys. In order to enable refinement of the alloy structure and adjustment of precipitation amounts of compounds, the inventors reduced the Bi content, and then comprehensively examined the contents of other additive elements.

As a result, it is considered that the Co content should be increased with a reduced Bi content, but the present inventors have found that even with an alloy composition with a reduced Bi content, a high Co content provides even better heat cycle resistance. In Sn-Ag-Cu-Bi-Sb-Fe-Co solder alloys with high Co content, crystal nuclei are sufficiently generated, so that it is presumed that supercooling of the molten solder can be avoided more sufficiently. When the supercooling condition is suppressed, the precipitated crystal grains are less likely to grow, resulting in a finer alloy structure and the heat cycle resistance is improved. On the other hand, excessive Co content may increase the liquidus temperature. Therefore, it is presumed that there is an optimum range for the Co content.

The reason why the heat cycle resistance is improved as the alloy structure becomes finer is presumed to be as follows. As mentioned above, in the heat cycle environment, electronic components and printed circuit boards, which have significantly different coefficients of linear thermal expansion, each repeat thermal expansion and contraction, and thus stress is continually applied to the solder joint. If the structure of the solder alloy that constitutes the solder joint becomes finer, the interface area of the crystal grains becomes larger, and it is presumed that the stress is more easily relieved through the interface.

However, in the solder alloys described in Patent Document 1, since coarse SnCo compounds were precipitated by simply increasing the Co content as well as reducing the Bi content, no findings were obtained that satisfied excellent heat cycle resistance. This is because solder alloys can exert their inherent effects only when all the constituent elements are united, rather than when each constituent element functions separately.

Therefore, the inventors adjusted the content of Bi and Co to moderate levels, and also investigated the content of other constituent elements in detail. As a result, the inventors found that when excellent heat cycle resistance and heat conductivity could be simultaneously obtained only when the contents of the respective constituent elements fell within specific ranges, and completed the present invention. Although an electronic circuit is exemplified in the present invention, the use application is not limited thereto as long as it requires these effects to be exerted at the same time.

The present invention obtained from these findings are as follows.

(0) A solder alloy consisting of, by mass%,

Ag: 3.0 to 3.8%,
Cu: 0.1 to 1.0%,
Bi: more than 0% and less than 1.5%,
Sb: 1.0 to 7.9%,

Fe: 0.020 to 0.040%,

Co: more than 0.008% and 0.020% or less, with the balance being Sn.

(1) A solder alloy having an alloy composition consisting of, by mass%,

Ag: 3.0 to 3.8%,

Cu: 0.1 to 1.0%,

Bi: more than 0% and less than 1.5%,

Sb: 1.0 to 7.9%,

Fe: 0.020 to 0.040%,

Co: more than 0.008% and 0.020% or less, with the balance being Sn.

(2) The solder alloy according to (0) or (1) above, wherein the alloy composition further comprises, by mass%, at least one of Ge, Ga, As, Pd, Mn, In, Zn, Zr, and Mg: 0.1% or less in total.

(3) A solder paste comprising a solder powder consisting of the solder alloy according to any one of (0) to (2) above.

(4) A solder ball consisting of the solder alloy according to any one of (0) to (2) above.

(5) A solder preform consisting of the solder alloy according to any one of (0) to (2) above.

(6) A solder joint comprising the solder alloy according to any one of (0) to (2) above.

(7) A vehicle-mounted electronic circuit comprising the solder alloy according to any one of (0) to (2) above.

(8) An ECU electronic circuit comprising the solder alloy according to any one of (0) to (2) above.

(9) A vehicle-mounted electronic circuit device comprising the vehicle-mounted electronic circuit according to (7) above.

(10) An ECU electronic circuit device comprising the ECU electronic circuit according to (8) above.

Brief Description of Drawings

Fig. 1 is an image showing results of cross-section observation in Example 10.

Fig. 2 is an image showing results of cross-section observation in Comparative Example 12.

Description of Embodiments

The present invention is described in more detail below. In the present specification, "%" used for indicating a solder alloy composition is "mass%" unless otherwise specified.

1. Solder Alloy

(1) Ag: 3.0 to 3.8%

Ag contributes to an improvement in heat cycle resistance since it forms a network structure of $Ag_3Sn$. If the Ag content is more than 3.8 mass%, the liquidus-line temperature of the solder alloy rises, Sb is not re-dissolved, SnSb is not refined, and the heat cycle resistance deteriorates. In addition, due to precipitation of coarse $Ag_3Sn$, the heat cycle resistance and the heat conductivity deteriorate. In terms of the upper limit, the Ag content is 3.8% or less, preferably 3.6% or less, more preferably 3.5% or less, and further preferably 3.4% or less.

On the other hand, if the Ag content is less than 3.0%, a network structure of $Ag_3Sn$ is not formed, heat conduction becomes uneven due to $Ag_3Sn$, and the heat conductivity tends to deteriorate. In addition, the heat cycle resistance also deteriorates. In terms of the lower limit, the Ag content is 3.0% or more, preferably 3.1% or more, more preferably 3.2% or more, and further preferably 3.3% or more.

(2) Cu: 0.1 to 1.0%

Cu can prevent Cu leaching from a Cu land, maintain excellent heat conductivity and heat cycle resistance, and further, decrease the liquidus-line temperature. If the Cu content is much higher than 1.0%, the liquidus-line temperature may increase. In addition, a coarse $Cu_6Sn_5$ compound is formed, and accordingly, the heat conductivity and the heat cycle resistance also deteriorate. In terms of the upper limit, the Cu content is 1.0% or less, preferably 0.9% or less, more preferably 0.8% or less, and further preferably 0.7% or less.

On the other hand, if the Cu content is less than 0.1%, Cu of an electrode diffuses into the solder alloy from a joint interface of a solder joint, and a CuSn-based compound is formed in the solder alloy, and accordingly, the heat cycle resistance and the heat conductivity deteriorate. In terms of the lower limit, the Cu content is 0.1% or more, preferably 0.3% or more, more preferably 0.5% or more, and further preferably 0.6% or more.

(3) Sb: 1.0 to 7.9%

Sb assumes a state dissolved in Sn at 125°C of a heat cycle test, and as the temperature decreases, Sb in the Sn matrix is gradually dissolved in a supersaturated state. Then, when Bi falls within the range described below, a structure that precipitates as an SnSb compound is formed at -40°C. Accordingly, the solder alloy according to the present invention is excellent in heat cycle resistance since solid solution strengthening of the solder alloy is caused when the temperature is high, and precipitation strengthening is caused when the temperature is low. If the Sb content is more than 7.9%, the liquidus-line temperature may rise. In addition, a precipitation amount of coarse SnSb compound increases, and the heat cycle resistance and the heat conductivity deteriorate. Additionally, embrittlement of the solder alloy occurs. In terms of the upper limit, the Sb content is 7.9% or less, preferably 7.0% or less, more preferably 6.0% or less, further preferably 5.0% or less, particularly preferably 4.0% or less, and most preferably 3.8% or less, and may be 3.5% or less or 3.2% or less.

On the other hand, if the Sb content is less than 1.0%, precipitation strengthening does not occur, and solid solution strengthening also becomes insufficient, so that the heat cycle resistance deteriorates. In terms of the lower limit, the Sb content is 1.0% or more, preferably 1.2% or more, more preferably 1.5% or more, further preferably 1.8% or more, particularly preferably 2.0% or more, and most preferably 2.2% or more, and may be 2.5% or more, 2.8% or more, or 3.0% or more.

(4) Bi: more than 0% and less than 1.5%,

Bi contributes to decreases in solidus-line temperature and liquidus-line temperature, and an improvement in the heat cycle resistance. Bi is substituted for Sb of the SnSb compound and has a higher atomic weight than Sb and has a great effect of distorting the crystal lattice, so that Bi can improve the heat cycle resistance. Bi does not obstruct formation of a fine SnSb compound, and maintains a precipitation-strengthened solder alloy.

In the conventional Sn-Ag-Cu-Bi-Sb-Fe-Co solder alloy, it was considered that, if the Bi content was less than 1.5%, due to a small precipitation amount of fine SnSb, an improvement in heat cycle resistance could not be expected. In the conventional solder alloy, according to addition of a large amount of Bi, a precipitation amount of the Bi phase increased, and the heat conductivity was low.

However, high heat conductivity is required for solder joints, so that when heat cycle resistance can be shown to an extent that causes no problem in practical use, solder joints more excellent than conventional solder joints can be formed. Therefore, in the solder alloy according to the present invention, for an improvement in heat conductivity, it is necessary to adjust the compound precipitation amount, and the Bi content is smaller than that in the conventional solder alloy. Even when refinement of SnSb does not reach the level in the conventional solder alloy because of the reduced Bi content, the solder alloy according to the present invention contains Fe and Co that contribute to refinement of the alloy structure, and can show heat cycle resistance to an extent that causes no problem in practical use.

If the Bi content is more than 0% and less than 1.5%, the compound precipitation amount decreases and segregation of Bi is suppressed, so that heat cycle resistance and high heat conductivity can be shown. In addition, the ductility of the solder alloy is improved, and hardening and embrittlement of the solder alloy can be avoided, so that the heat cycle resistance can be maintained at a level that poses no problem in practical use. If Bi is not contained, the effect of Bi addition is not exerted, and the heat cycle resistance are poor. If the Bi content is increased to 1.5% or more, the precipitation amount of the Bi phase increases, so that the heat conductivity decreases. If the Bi content is much higher than 1.5%, supercooling occurs, and the solidus-line temperature decreases. In terms of the upper limit, the Bi content is less than 1.5%, preferably 1.4% or less, more preferably 1.2% or less, and further preferably 1.0% or less. In terms of the lower limit, the Bi content is more than 0%, preferably 0.1% or more, more preferably 0.2% or more, further preferably 0.3% or more, and particularly preferably 0.5% or more.

(5) Fe: 0.020 to 0.040%

Fe functions as a solidification nucleus at the time of solidification of molten solder, and therefore, refines Sn crystal grains by suppressing supercooling, and contributes to an improvement in heat cycle resistance. If the Fe content is much higher than 0.040%, the liquidus-line temperature may increase. Further, a coarse SnFe compound precipitates, so that the heat cycle resistance deteriorates. If the Fe content is so high as to cause an increase in liquidus-line temperature, the heat conductivity deteriorates. In terms of the upper limit, the Fe content is 0.040% or less, preferably 0.030% or less.

On the other hand, if the Fe content is less than 0.020%, supercooling is not suppressed, so that the alloy structure does not become fine, and the heat cycle resistance is poor. In terms of the lower limit, the Fe content is 0.020% or more, preferably 0.025% or more.

(6) Co: more than 0.008% and 0.020% or less

Like Fe, Co functions as a solidification nucleus at the time of solidification of molten solder, so that Sn crystal grains become fine due to suppression of supercooling, and the heat cycle resistance is improved. If the Co content is more than 0.020%, the liquidus-line temperature may increase. Further, a coarse SnCo compound precipitates, so that the heat cycle resistance deteriorates. In terms of the upper limit, the Co content is 0.020% or less, and preferably 0.010% or less.

On the other hand, if the Co content is more than 0.008%, supercooling is suppressed, so that the alloy structure becomes fine, and the heat cycle resistance is improved. In terms of the lower limit, the Co content is more than 0.008%, and preferably 0.009% or more.

(7) By mass%, at least one of Ge, Ga, As, Pd, Mn, In, Zn, Zr, and Mg: 0.1% or less in total

The solder alloy according to the present invention may contain optional elements without impairing the effects of the present invention. As long as these optional elements are 0.1% or less in total, the effects of the present invention are maintained. The lower limit is not limited, but may be at least 0.001% or more.

(8) Balance: Sn

The balance of the solder alloy according to the present invention is Sn. In addition to the above-described elements, unavoidable impurity may be contained. The balance of the solder alloy according to the present invention may consist of Sn and unavoidable impurities. Even when the solder alloy contains unavoidable impurities, this inclusion does not affect the effects described above. Ni promotes liberation of a compound that precipitates at a joint interface of a solder j oint, so that Ni should not be contained.

The solder alloy according to the present invention is preferably in a temperature range that does not cause member erosion, position shift, reoxidation, and generation of voids, etc., so as not to deteriorate the mountability. The solidus-line temperature of the solder alloy according to the present invention is preferably 200°C or more, and more preferably 210°C or more. An upper limit of the solidus-line temperature may be required to be equal to or less than the liquidus-line temperature, and required to be 250°C or less although not particularly limited. The liquidus-line temperature may be required to be 250°C or less, and preferably 230°C or less, because the melting temperature of the solder alloy should not be higher. A lower limit of the liquidus-line temperature may be required to be equal to or more than the solidus-line temperature.

2. Solder Paste

A solder paste according to the present invention is a mixture of a solder powder containing the solder alloy having the alloy composition described above and a flux. The flux used in the present invention is not particularly limited as long as it is suitable for soldering by a conventional method. Accordingly, a commonly used rosin, an organic acid, an activator, and a solvent may be blended as appropriate for use. In the present invention, a blending ratio of a metal powder component to a flux component is not particularly limited, but preferably the metal powder component is 80 to 90 mass% while the flux component is 10 to 20 mass%.

3. Solder Ball

The solder alloy according to the present invention can be used as a solder ball. When the solder alloy is used as a solder ball, the solder ball can be produced from the solder alloy according to the present invention by using a dropping method as a common method in the industry. A solder joint can be produced by processing using a common method in the industry such as a method in which one solder ball is mounted on one flux-applied electrode and joined. A grain size of the solder ball is preferably 1 $\mu$m or more, more preferably 10 $\mu$m or more, further preferably 20 $\mu$m or more, and particularly preferably 30 $\mu$m or more. An upper limit of the grain size of the solder ball is preferably 3000 $\mu$m or less, more preferably 1000 $\mu$m or less, further preferably 800 $\mu$m or less, and particularly preferably 600 $\mu$m or less.

4. Solder Preform

The solder alloy according to the present invention can be used as a preform. A form of the preform is a washer, a ring, a pellet, a disc, a ribbon, a wire, etc.

5. Solder Joint

A solder joint according to the present invention is suitably used for joining at least two or more members to be joined. The members to be joined are, for example, a circuit element, a substrate, an electronic component, a printed circuit board, an insulating substrate, a heat sink, a lead frame, a semiconductor using electrode terminals, etc., as well as a power module and an inverter product, and are not particularly limited as long as they are electrically connected using the solder alloy according to the present invention.

A joining method using the solder alloy according to the present invention is performed in the usual manner by using, for example, a reflow method. A melting temperature of the solder alloy when flow soldering is performed may be a temperature approximately 20°C higher than the liquidus-line temperature. In the case of joining using the solder alloy according to the present invention, the alloy structure can be made finer taking a cooling rate for solidification into consideration. For example, a solder joint is cooled at a cooling rate of 2 to 3 °C/s or more. Other joining conditions can be adjusted as appropriate according to the alloy composition of the solder alloy.

6. Vehicle-Mounted Electronic Circuit, ECU Electronic Circuit, Vehicle-Mounted Electronic Circuit Device, ECU Electronic Circuit Device

The solder alloy according to the present invention is excellent in heat cycle resistance and heat conductivity as is clear from the description given above. Therefore, even when the solder alloy is used for an automobile, that is, used in a vehicle-mounted form that is exposed to a harsh environment, growth and development of cracks are not promoted. Therefore, the solder alloy according to the present invention is found particularly suitable for soldering of electronic circuits to be mounted in an automobile because the solder alloy according to the present invention has such remarkable properties.

"Excellent in heat cycle resistance" set forth in this description means that, as shown in examples described later, even when a heat cycle test is conducted at -40°C or less and +125°C or more, a shear strength residual rate after 3500 cycles is 40% or more.

Such properties means that, even when used under extremely harsh conditions as in the case of the heat cycle test, the vehicle-mounted electronic circuit is not broken, that is, does not become inoperable or fail. Further, the solder alloy according to the present invention has an excellent shear strength residual rate after subjected to the heat cycles. That is, resistance to external forces, such as shear strength, does not deteriorate even after a long period of use.

As described above, the solder alloy according to the present invention is used for, more specifically, soldering of vehicle-mounted electronic circuits, or soldering of ECU electronic circuits, and exerts excellent heat cycle resistance.

An "electronic circuit" is a system that causes a plurality of electronic components each having functions to perform a target function as a whole according to an electronic combination of the electronic components.

Such electronic components constituting an electronic circuit are chip resistor components, multiple resistor components, QFPs, QFNs, power transistors, diodes, capacitors, etc., by way of example. An electronic circuit in which these electronic components are incorporated is provided on a board, and constitutes an electronic circuit device.

In the present invention, a board constituting such an electronic circuit device, for example, a printed wiring board is not particularly limited. The board is a heat-resistant plastic board (example: high-Tg low-CTE FR-4) by way of example although the material of the board is not particularly limited. The printed wiring board is preferably a printed circuit board whose Cu land surface is treated with an organic substance (OSP: Organic Surface Protection) such as amine or imidazole.

7. Other

As the solder alloy according to the present invention, by using a low $\alpha$ dose material as a raw material, a low $\alpha$ dose alloy can be produced. Such a low $\alpha$ dose alloy can prevent a soft error when used for forming solder bumps around a memory.

Examples

The present invention will be described based on the following examples, however, the present invention is not limited to the following examples.

In order to demonstrate the effects of the present invention, by using solder alloys described in Tables 2 and 3, (1) solidus-line temperature and liquidus-line temperature, (2) heat conductivity, (3) liberation, and (4) heat cycle resistance.

(1) Solidus-Line Temperature and Liquidus-Line Temperature

Concerning the solder alloys having the respective alloy compositions described in Tables 2 and 3, their temperatures were obtained from the DSC curves. The DSC curve was obtained with a DSC (model number: Q2000) manufactured by Seiko Instruments Inc., by raising the temperature at 5 °C/min in the atmosphere. From the obtained DSC curve, a liquidus-line temperature was obtained and defined as a melting temperature. In addition, the solidus-line temperature was also evaluated from the DSC curve. A case where the solidus-line temperature was 210°C or more and the liquidus-line temperature was less than 230°C was judged as "Excellent". A case where the solidus-line temperature was 210°C or more and the liquidus-line temperature was 230°C or more and 250°C or less was judged as "Good". A case where the solidus-line temperature was less than 210°C or the liquidus-line temperature was more than 250°C was judged as "Poor".

(2) Heat Conductivity

By using sheets of the solder alloys described in Tables 2 and 3, samples with $\phi$10 mm and a thickness of 3 mm were produced. For obtaining heat conductivities of these samples, thermal diffusivity $\alpha$ of each sample was measured three times according to a laser flash method by using a thermal conductivity meter (manufactured by ADVANCE RIKO, Inc., meter name: TC7000), and a value calculated by dividing the sum of three measurements by 3 was obtained as a heat conductivity average value. Specific heat C (J/(g·K)) of each sample was measured three times, and a value calculated by dividing the sum of three measurements by 3 was obtained as a specific heat average value. Then, by using a density $\rho$ obtained according to the Archimedes method, heat conductivity $\lambda$ was calculated according to the following relation. A case where the heat conductivity was 50 [W/m/K] or more was judged as "Excellent," a case where the heat conductivity was 48 [W/m/K] or more and less than 50 [W/m/K] was judged as "Good," and a case where the heat conductivity was less than 48 [W/m/K] was judged as "Poor".

$$\lambda = \alpha \times C \times \rho$$

(3) liberation

A powder of each of the solder alloys described in Tables 2 and 3 was prepared by an atomizing method. The powder of the alloy was mixed with a flux ("GLV" made by Senju Metal Industry Co., Ltd.) containing rosin, a solvent, a thixotropic agent, and an organic acid, etc., to prepare a solder paste. The alloy powder in the solder paste was set to 88 mass%, and the flux was set to 12 mass%. This solder paste was pasted and printed on a Cu land of a six-layer printed circuit board (FE-4, Cu-OSP) with a 150 $\mu$m metal mask, and then a 3216 chip resistor was mounted by a mounter. Then, a test board was produced by performing reflow soldering by melting the solder paste under heating conditions where a maximum temperature was 245°C in the atmosphere and a holding time was 40 seconds.

After that, the test board was cut out and polished, and the vicinity of a joint interface in a cross section was observed at a magnification of 1000. A total area and an area of the CuSn-based compound were calculated by using image analysis software. As the image analysis software, Scandium was used. By using results of calculation of the respective areas, an area ratio of the CuSn-based compound was calculated according to (area ratio of CuSn-based compound) (%) = (area of CuSn-based compound) $\times$ 100 / (area of target region).

In detail, 5 samples were prepared for each of the examples and the comparative examples, and an alloy layer and a region of 5 to 15 $\mu$m from a surface treatment interface were observed. A case where the average area ratio of CuSn compounds liberated from the bonding interface (average value of 5 samples) was less than 1% was judged as "Good", and if the average area ratio of CuSn compounds (average value of 5 samples) is 1% or more was judged as "Poor".

(4) Heat Cycle Resistance (TCT)

(4-1) Preparation of Paste

Powder of each of the solder alloys described in Tables 2 and 3 was prepared according to an atomizing method. Powder of this alloy was mixed with a flux ("GLV" made by Senju Metal Industry Co., Ltd.) containing rosin, a solvent, a thixotropic agent, and organic acid, etc., to prepare a solder paste. The alloy powder in the solder paste was set to 88 mass%, and the flux was set to 12 mass%. This solder paste was pasted and printed on a Cu land of a six-layer printed board (FR-4, Cu-OSP) with a 150 $\mu$m metal mask, and then a 3216 chip resistor was mounted by a mounter. Then, a test board was produced by performing soldering by reflow by melting the solder paste under heating conditions where a maximum temperature was 245°C in the atmosphere and a holding time was 40 seconds.

This test board was put into a heat cycle testing machine set to conditions of a low temperature of -40°C, a high temperature of +125°C, and a holding time of 30 minutes, and after 3500 cycles, the test board was taken out of the heat cycle testing machine under each condition and subjected to a shear test.

(4-2) Shear Strength Reliability (Shear Strength Residual Rate)

The shear strength test was conducted for each sample (5 samples of each of the examples and comparative examples) after 3500 cycles described above by using a joint strength tester STR-5100 under conditions of 25°C, a test speed of 6 mm/min, and a test height of 100 $\mu$m. The shear strength residual rate (%) was obtained according to (shear strength after heat cycle test) $\times$ 100 / (initial shear strength). In this example, a case where an average value of the shear strength residual rate was 40% or more was judged as "Excellent," and a case where the average value was less than 40% was judged as "Poor".

[Table 2]

| | Alloy composition (mass%) | | | | | | | | Evaluation 1 | | | Evaluation 2 | Evaluation 3 | Evaluation 4 | |
| | Sn | Ag | Cu | Bi | Sb | Fe | Co | Optional element | Solidus-line temperature (°C) | Liquidus-line temperature (°C) | Judgment | Heat conductivity | Liberation | TCT | Overall evaluation |
|---|---|---|---|---|---|---|---|---|---|---|---|---|---|---|---|
| Ex. 1 | Bal. | 3.1 | 0.7 | 1.0 | 3.0 | 0.025 | 0.009 | | 214 | 220 | Excellent | Excellent | Good | Excellent | Excellent |
| Ex. 2 | Bal. | 3.7 | 0.7 | 1.0 | 3.0 | 0.040 | 0.009 | | 214 | 221 | Excellent | Good | Good | Excellent | Excellent |
| Ex. 3 | Bal. | 3.8 | 0.7 | 1.0 | 3.0 | 0.025 | 0.009 | | 214 | 221 | Excellent | Good | Good | Excellent | Excellent |
| Ex. 4 | Bal. | 3.4 | 0.1 | 1.0 | 3.0 | 0.025 | 0.009 | | 214 | 222 | Excellent | Excellent | Good | Excellent | Excellent |
| Ex. 5 | Bal. | 3.4 | 1.0 | 1.0 | 3.0 | 0.025 | 0.009 | | 214 | 219 | Excellent | Good | Good | Excellent | Excellent |
| Ex. 6 | Bal. | 3.4 | 0.7 | 0.1 | 3.0 | 0.025 | 0.009 | | 217 | 220 | Excellent | Excellent | Good | Excellent | Excellent |
| Ex. 7 | Bal. | 3.4 | 0.7 | 0.3 | 3.0 | 0.025 | 0.009 | | 216 | 220 | Excellent | Excellent | Good | Excellent | Excellent |
| Ex. 8 | Bal. | 3.4 | 0.7 | 0.5 | 3.0 | 0.025 | 0.009 | | 216 | 220 | Excellent | Excellent | Good | Excellent | Excellent |
| Ex. 9 | Bal. | 3.4 | 0.7 | 0.8 | 3.0 | 0.025 | 0.009 | | 215 | 219 | Excellent | Excellent | Good | Excellent | Excellent |
| Ex. 10 | Bal. | 3.4 | 0.7 | 1.0 | 3.0 | 0.025 | 0.009 | | 214 | 219 | Excellent | Excellent | Good | Excellent | Excellent |
| Ex. 11 | Bal. | 3.4 | 0.7 | 1.2 | 3.0 | 0.025 | 0.009 | | 213 | 218 | Excellent | Excellent | Good | Excellent | Excellent |
| Ex. 12 | Bal. | 3.4 | 0.7 | 1.4 | 3.0 | 0.025 | 0.009 | | 213 | 218 | Excellent | Excellent | Good | Excellent | Excellent |
| Ex. 13 | Bal. | 3.4 | 0.7 | 1.0 | 1.0 | 0.025 | 0.009 | | 213 | 218 | Excellent | Excellent | Good | Excellent | Excellent |
| Ex. 14 | Bal. | 3.4 | 0.7 | 1.0 | 1.2 | 0.025 | 0.009 | | 213 | 218 | Excellent | Excellent | Good | Excellent | Excellent |
| Ex. 15 | Bal. | 3.4 | 0.7 | 1.0 | 1.5 | 0.025 | 0.009 | | 214 | 218 | Excellent | Excellent | Good | Excellent | Excellent |
| Ex. 16 | Bal. | 3.4 | 0.7 | 1.0 | 1.8 | 0.025 | 0.009 | | 214 | 219 | Excellent | Excellent | Good | Excellent | Excellent |
| Ex. 17 | Bal. | 3.4 | 0.7 | 1.0 | 2.0 | 0.025 | 0.009 | | 214 | 219 | Excellent | Excellent | Good | Excellent | Excellent |
| Ex. 18 | Bal. | 3.4 | 0.7 | 1.0 | 2.2 | 0.025 | 0.009 | | 214 | 219 | Excellent | Excellent | Good | Excellent | Excellent |
| Ex. 19 | Bal. | 3.4 | 0.7 | 1.0 | 2.5 | 0.025 | 0.009 | | 214 | 219 | Excellent | Excellent | Good | Excellent | Excellent |
| Ex. 20 | Bal. | 3.4 | 0.7 | 1.0 | 2.8 | 0.025 | 0.009 | | 214 | 219 | Excellent | Excellent | Good | Excellent | Excellent |
| Ex. 21 | Bal. | 3.4 | 0.7 | 1.0 | 3.0 | 0.025 | 0.009 | | 214 | 219 | Excellent | Excellent | Good | Excellent | Excellent |
| Ex. 22 | Bal. | 3.4 | 0.7 | 1.0 | 3.2 | 0.025 | 0.009 | | 214 | 219 | Excellent | Excellent | Good | Excellent | Excellent |
| Ex. 23 | Bal. | 3.4 | 0.7 | 1.0 | 3.5 | 0.025 | 0.009 | | 214 | 219 | Excellent | Excellent | Good | Excellent | Excellent |

| | Alloy composition (mass%) | | | | | | | | Evaluation 1 | | | Evaluation 2 | Evaluation 3 | Evaluation 4 | |
| | Sn | Ag | Cu | Bi | Sb | Fe | Co | Optional element | Solidus-line temperature (°C) | Liquidus-line temperature (°C) | Judgment | Heat conductivity | Liberation | TCT | Overall evaluation |
|---|---|---|---|---|---|---|---|---|---|---|---|---|---|---|---|
| Ex. 24 | Bal. | 3.4 | 0.7 | 1.0 | 3.8 | 0.025 | 0.009 | | 214 | 219 | Excellent | Excellent | Good | Excellent | Excellent |
| Ex. 25 | Bal. | 3.4 | 0.7 | 1.0 | 4.0 | 0.025 | 0.009 | | 214 | 219 | Excellent | Excellent | Good | Excellent | Excellent |
| Ex. 26 | Bal. | 3.4 | 0.7 | 1.0 | 5.0 | 0.025 | 0.009 | | 215 | 220 | Excellent | Good | Good | Excellent | Excellent |
| Ex. 27 | Bal. | 3.4 | 0.7 | 1.0 | 6.0 | 0.025 | 0.009 | | 214 | 220 | Excellent | Good | Good | Excellent | Excellent |
| Ex. 28 | Bal. | 3.4 | 0.7 | 1.0 | 7.0 | 0.025 | 0.009 | | 215 | 225 | Excellent | Good | Good | Excellent | Excellent |
| Ex. 29 | Bal. | 3.4 | 0.7 | 1.0 | 7.9 | 0.025 | 0.009 | | 215 | 233 | Good | Good | Good | Excellent | Excellent |
| Ex. 30 | Bal. | 3.4 | 0.7 | 1.0 | 3.0 | 0.020 | 0.009 | | 214 | 219 | Excellent | Excellent | Good | Excellent | Excellent |
| Ex. 31 | Bal. | 3.4 | 0.7 | 1.0 | 3.0 | 0.040 | 0.009 | | 214 | 233 | Good | Good | Good | Excellent | Excellent |
| Ex. 32 | Bal. | 3.4 | 0.7 | 1.0 | 3.0 | 0.025 | 0.020 | | 214 | 219 | Excellent | Good | Good | Excellent | Excellent |
| Ex. 33 | Bal. | 3.4 | 0.7 | 1.0 | 3.0 | 0.025 | 0.009 | Ge:0.008 | 214 | 219 | Excellent | Excellent | Good | Excellent | Excellent |
| Ex. 34 | Bal. | 3.4 | 0.7 | 1.0 | 3.0 | 0.025 | 0.009 | Ga:0.008 | 214 | 219 | Excellent | Excellent | Good | Excellent | Excellent |
| Ex. 35 | Bal. | 3.4 | 0.7 | 1.0 | 3.0 | 0.025 | 0.009 | As:0.008 | 214 | 219 | Excellent | Excellent | Good | Excellent | Excellent |
| Ex. 36 | Bal. | 3.4 | 0.7 | 1.0 | 3.0 | 0.025 | 0.009 | Pd:0.008 | 214 | 219 | Excellent | Excellent | Good | Excellent | Excellent |
| Ex. 37 | Bal. | 3.4 | 0.7 | 1.0 | 3.0 | 0.025 | 0.009 | Mn:0.008 | 214 | 219 | Excellent | Excellent | Good | Excellent | Excellent |
| Ex. 38 | Bal. | 3.4 | 0.7 | 1.0 | 3.0 | 0.025 | 0.009 | In:0.008 | 214 | 219 | Excellent | Excellent | Good | Excellent | Excellent |
| Ex. 39 | Bal. | 3.4 | 0.7 | 1.0 | 3.0 | 0.025 | 0.009 | Zn:0.008 | 214 | 219 | Excellent | Excellent | Good | Excellent | Excellent |
| Ex. 40 | Bal. | 3.4 | 0.7 | 1.0 | 3.0 | 0.025 | 0.009 | Zr:0.008 | 214 | 219 | Excellent | Excellent | Good | Excellent | Excellent |
| Ex. 41 | Bal. | 3.4 | 0.7 | 1.0 | 3.0 | 0.025 | 0.009 | Mg:0.008 | 214 | 219 | Excellent | Excellent | Good | Excellent | Excellent |
| Ex. = Example | | | | | | | | | | | | | | | |

[Table 3]

| | Alloy composition (mass%) | | | | | | | | Evaluation 1 | | | Evaluation 2 | Evaluation 3 | Evaluation 4 | |
| | Sn | Ag | Cu | Bi | Sb | Fe | Co | Optional element | Solidus-line temperature (°C) | Liquidus-line temperature (°C) | Judgment | Heat conductivity | Liberation | TCT | Overall evaluation |
|---|---|---|---|---|---|---|---|---|---|---|---|---|---|---|---|
| Comp. Ex. 1 | Bal. | 3.4 | 0.04 | 0.5 | 3.0 | 0.025 | 0.009 | | 216 | 223 | Excellent | Poor | Good | Poor | Poor |
| Comp. Ex. 2 | Bal. | 3.4 | 1.05 | 0.5 | 3.0 | 0.025 | 0.009 | | 216 | 221 | Excellent | Poor | Good | Poor | Poor |
| Comp. Ex. 3 | Bal. | 3.4 | 0.7 | 0.0 | 3.0 | 0.025 | 0.009 | | 217 | 220 | Excellent | Excellent | Good | Poor | Poor |
| Comp. Ex. 4 | Bal. | 3.4 | 0.7 | 1.5 | 3.0 | 0.025 | 0.009 | | 217 | 220 | Excellent | Poor | Good | Excellent | Poor |
| Comp. Ex. 5 | Bal. | 3.4 | 0.7 | 0.7 | 0.9 | 0.025 | 0.009 | | 212 | 218 | Excellent | Excellent | Good | Poor | Poor |
| Comp. Ex. 6 | Bal. | 3.4 | 0.7 | 0.5 | 8.0 | 0.025 | 0.009 | | 217 | 234 | Good | Poor | Good | Poor | Poor |
| Comp. Ex. 7 | Bal. | 3.4 | 0.7 | 0.5 | 3.0 | 0.010 | 0.009 | | 216 | 220 | Excellent | Excellent | Good | Poor | Poor |
| Comp. Ex. 8 | Bal. | 3.4 | 0.7 | 0.5 | 3.0 | 0.060 | 0.009 | | 216 | 220 | Excellent | Excellent | Good | Poor | Poor |
| Comp. Ex. 9 | Bal. | 3.4 | 0.7 | 1.0 | 3.0 | 0.050 | 0.008 | | 214 | 219 | Excellent | Excellent | Good | Poor | Poor |
| Comp. Ex. 10 | Bal. | 3.4 | 0.7 | 1.0 | 3.0 | 0.025 | 0.030 | | 214 | 231 | Good | Good | Good | Poor | Poor |
| Comp. Ex. 11 | Bal. | 3.4 | 0.7 | 5.0 | 6.0 | 0.020 | 0.025 | Ni:0.01 | 199 | 227 | Poor | Poor | Poor | Excellent | Poor |
| Comp. Ex. 12 | Bal. | 3.4 | 0.7 | 0.5 | 3.0 | 0.025 | 0.009 | Ni:0.01 | 216 | 220 | Excellent | Good | Poor | Excellent | Poor |

Comp. Ex. = Comparative Example
* The underline indicates that it does not fall within the scope of the present invention.

As is clear from Tables 2 and 3, all of Examples 1 to 41 were judged as "Good" or "Excellent" in all evaluations since all of the contents of Ag, Cu, Bi, Sb, Fe, and Co fell within the scope of the present invention.

On the other hand, in Comparative Example 1 and 2, due to an improper content of Cu, the heat conductivity and TCT were poor. In Comparative Example 3, since Bi was not contained, TCT was poor. In Comparative Example 4, due to a high content of Bi, the heat conductivity was poor.

In Comparative Example 5, due to a low content of Sb, TCT was poor. In Comparative Example 6, due to a high content of Sb, the heat conductivity and TCT were poor. In Comparative Examples 7 to 9, due to an improper content of Fe, TCT was poor.

In Comparative Example 10, due to a high content of Co, TCT was poor. In Comparative Example 11, since a content of Bi was high and Ni was contained, the solidus-line temperature was low, the heat conductivity was poor, and liberation occurred. In Comparative Example 12, since Ni was contained, liberation occurred.

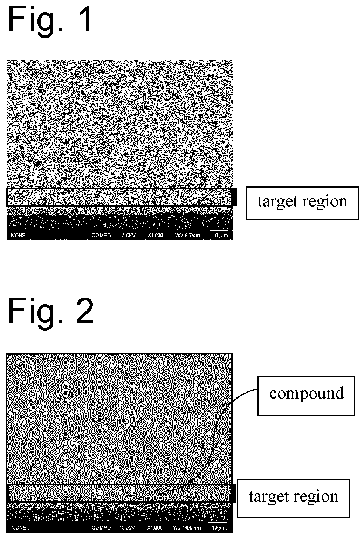

Results of checking whether liberation occurred are shown in Figs. 1 and 2. Fig. 1 is an image showing results of cross-section observation in Example 10. Fig. 2 is an image showing results of cross-section observation in Comparative Example 12. 5 samples were prepared for each of the examples and the comparative examples, and an alloy layer and a region of 5 to 15 μm from a surface treatment interface (region illustrated as "target region" in Figs. 1 and 2) were observed.

As is clear from Fig. 1, in the target region in Example 10, the area ratio of the CuSn-based compound was 0%. Fig. 2 illustrates an image of Comparative Example 12, and the area ratio of the CuSnNi-based compound was 15 to 20% in the target region. Thus, in the example, it was found that no compound liberation occurred.

**Claims**

1. A solder alloy having an alloy composition consisting of, by mass%,

   Ag: 3.0 to 3.8%,
   Cu: 0.1 to 1.0%,
   Bi: more than 0% and less than 1.5%,
   Sb: 1.0 to 7.9%,
   Fe: 0.020 to 0.040%,
   Co: more than 0.008% and 0.020% or less, with the balance being Sn.

2. The solder alloy according to claim 1, wherein the alloy composition further comprises, by mass%, at least one of Ge, Ga, As, Pd, Mn, In, Zn, Zr, and Mg: 0.1% or less in total.

3. A solder paste comprising a solder powder consisting of the solder alloy according to claim 1 or 2.

4. A solder ball consisting of the solder alloy according to claim 1 or 2.

5. A solder preform consisting of the solder alloy according to claim 1 or 2.

6. A solder joint comprising the solder alloy according to claim 1 or 2.

7. A vehicle-mounted electronic circuit comprising the solder alloy according to claim 1 or 2.

8. An ECU electronic circuit comprising the solder alloy according to claim 1 or 2.

9. A vehicle-mounted electronic circuit device comprising the vehicle-mounted electronic circuit according to claim 7.

10. An ECU electronic circuit device comprising the ECU electronic circuit according to claim 8.

# Fig. 1

target region

# Fig. 2

compound

target region

Europäisches
Patentamt

European
Patent Office

Office européen
des brevets

**EUROPEAN SEARCH REPORT**

Application Number

EP 24 15 1702

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 4 019 652 A1 (SENJU METAL INDUSTRY CO [JP]) 29 June 2022 (2022-06-29) <br> * claims 1-11 * <br> * tables 1-2 * <br> * paragraphs [0007] - [0081] * | 1-10 | INV. <br> B23K35/26 <br> C22C13/00 <br> C22C13/02 <br> B23K35/02 <br> H05K3/34 |
| A | JP 2019 104029 A (TAMURA SEISAKUSHO KK) 27 June 2019 (2019-06-27) <br> * the whole document * | 1-10 | |
| A | US 2022/032406 A1 (IIJIMA YUUKI [JP] ET AL) 3 February 2022 (2022-02-03) <br> * claims 1-8 * <br> * paragraphs [0012] - [0073] * <br> * tables 1-2 * | 1-10 | |
| A | US 2020/306895 A1 (IIJIMA YUKI [JP] ET AL) 1 October 2020 (2020-10-01) <br> * claims 1-11 * <br> * tables 1-2 * <br> * paragraphs [0020] - [0089] * | 1-10 | TECHNICAL FIELDS SEARCHED (IPC) |
| A | US 2016/056570 A1 (YOSHIKAWA SHUNSAKU [JP] ET AL) 25 February 2016 (2016-02-25) <br> * claims 1-19 * <br> * paragraphs [0009] - [0082] * <br> * tables 1-2 * | 1-10 | B23K <br> C22C <br> H05K |
| A | JP 2019 072770 A (SENJU METAL INDUSTRY CO) 16 May 2019 (2019-05-16) <br> * the whole document * | 1-10 | |

The present search report has been drawn up for all claims

| Place of search | Date of completion of the search | Examiner |
|---|---|---|
| The Hague | 15 April 2024 | Vlassi, Eleni |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 15 1702

15-04-2024

| Patent document cited in search report | | Publication date | Patent family member(s) | | Publication date |
|---|---|---|---|---|---|
| EP 4019652 | A1 | 29-06-2022 | BR | 112022004264 A2 | 31-05-2022 |
| | | | CA | 3156067 A1 | 30-12-2021 |
| | | | CN | 114746209 A | 12-07-2022 |
| | | | EP | 4019652 A1 | 29-06-2022 |
| | | | ES | 2960421 T3 | 04-03-2024 |
| | | | JP | 6889387 B1 | 18-06-2021 |
| | | | JP | 2022002855 A | 11-01-2022 |
| | | | KR | 20220065093 A | 19-05-2022 |
| | | | MY | 195124 A | 11-01-2023 |
| | | | PT | 4019652 T | 25-09-2023 |
| | | | TW | 202204079 A | 01-02-2022 |
| | | | US | 2022355420 A1 | 10-11-2022 |
| | | | WO | 2021261486 A1 | 30-12-2021 |
| JP 2019104029 | A | 27-06-2019 | JP | 6719443 B2 | 08-07-2020 |
| | | | JP | 2019104029 A | 27-06-2019 |
| US 2022032406 | A1 | 03-02-2022 | BR | 102021014263 A2 | 01-02-2022 |
| | | | CN | 114055009 A | 18-02-2022 |
| | | | EP | 3944923 A1 | 02-02-2022 |
| | | | JP | 6836040 B1 | 24-02-2021 |
| | | | JP | 2022026827 A | 10-02-2022 |
| | | | KR | 102314989 B1 | 21-10-2021 |
| | | | TW | I758214 B | 11-03-2022 |
| | | | US | 2022032406 A1 | 03-02-2022 |
| US 2020306895 | A1 | 01-10-2020 | BR | 102020006258 A2 | 17-02-2021 |
| | | | CN | 111745321 A | 09-10-2020 |
| | | | EP | 3715039 A1 | 30-09-2020 |
| | | | ES | 2887831 T3 | 28-12-2021 |
| | | | JP | 6624322 B1 | 25-12-2019 |
| | | | JP | 2020157349 A | 01-10-2020 |
| | | | KR | 102133347 B1 | 13-07-2020 |
| | | | MY | 188098 A | 18-11-2021 |
| | | | PH | 12020050051 A1 | 23-11-2020 |
| | | | PT | 3715039 T | 15-09-2021 |
| | | | TW | 202035726 A | 01-10-2020 |
| | | | US | 2020306895 A1 | 01-10-2020 |
| US 2016056570 | A1 | 25-02-2016 | BR | 112015025125 A2 | 18-07-2017 |
| | | | CN | 105142856 A | 09-12-2015 |
| | | | CN | 108581266 A | 28-09-2018 |
| | | | EP | 2982469 A1 | 10-02-2016 |
| | | | ES | 2718523 T3 | 02-07-2019 |
| | | | HU | E042401 T2 | 28-06-2019 |
| | | | JP | 5811304 B2 | 11-11-2015 |

EPO FORM P0459

For more details about this annex : see Official Journal of the European Patent Office, No. 12/82

**EP 4 400 253 A1**

## ANNEX TO THE EUROPEAN SEARCH REPORT
## ON EUROPEAN PATENT APPLICATION NO.

**EP 24 15 1702**

This annex lists the patent family members relating to the patent documents cited in the above-mentioned European search report.
The members are as contained in the European Patent Office EDP file on
The European Patent Office is in no way liable for these particulars which are merely given for the purpose of information.

**15-04-2024**

| Patent document cited in search report | Publication date | Patent family member(s) | Publication date |
|---|---|---|---|
| | | JP 2015077601 A | 23-04-2015 |
| | | JP WO2014163167 A1 | 16-02-2017 |
| | | KR 20150126385 A | 11-11-2015 |
| | | KR 20160148036 A | 23-12-2016 |
| | | MX 357114 B | 27-06-2018 |
| | | MY 158373 A | 26-09-2016 |
| | | PH 12015502283 A1 | 01-02-2016 |
| | | PT 2982469 T | 23-04-2019 |
| | | US 2016056570 A1 | 25-02-2016 |
| | | WO 2014163167 A1 | 09-10-2014 |
| JP 2019072770 A | 16-05-2019 | NONE | |

EPO FORM P0459

For more details about this annex : see Official Journal of the European Patent Office, No. 12/82

**EP 4 400 253 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6889387 B